# EUROPÄISCHE PATENTSCHRIFT

(11) **EP 1 688 518 B1**
(45) Veröffentlichungstag und Bekanntmachung des Hinweises auf die Patenterteilung: **23.07.2008**
(21) Anmeldenummer: 06002263.9
(22) Anmeldetag: 03.02.2006
(51) Int. Cl.: C25D 17/10, C25D 5/18, C25D 17/00, C25D 7/06

(54) **Verfahren und Vorrichtung zur elektrochemischen Behandlung von Bauteilen in Durchlaufanlagen**
Process and apparatus for continuous electrochemical treatment of pieces
Procédé et appareil pour l'électroplacage en continu de pieces

(30) Priorität: 04.02.2005 DE 102005005095
(43) Veröffentlichungstag der Anmeldung: 09.08.2006
(73) Patentinhaber: Höllmüller Maschinenbau GmbH, 71083 Herrenberg (DE)
(72) Erfinder: Kosikowski, Thomas, 90559 Burgthann (DE)
(74) Vertreter: Ostertag, Ulrich

(56) Entgegenhaltungen:
- EP-A2- 1 083 245
- WO-A-03/072855
- DE-A1- 4 417 551
- MANDICH N V: "Pulse and pulse-reverse electroplating" MET. FINISH.; METAL FINISHING JANUARY 2002, Bd. 100, Nr. 1SUPPL, Januar 2002 (2002-01), Seiten 359-364, XP002405319
- KALANTARY M R ET AL: "UNIPOLAR AND BIPOLAR PULSED CURRENT ELECTRODEPOSITION FOR PCB PRODUCTION" JOURNAL OF APPLIED ELECTROCHEMISTRY, SPRINGER, DORDRECHT, NL, Bd. 23, Nr. 3, 1993, Seiten 231-240, XP008070194 ISSN: 0021-891X

## Beschreibung

Die Erfindung betrifft ein Verfahren und eine Vorrichtung zum Galvanisieren und zum elektrolytischen Ätzen von ebenen Bauteilen, insbesondere von Leiterplatten und Leiterfolien, in Durchlaufanlagen mit horizontalem oder vertikalem Transport der Bauteile. Nachfolgend werden die Bauteile auch als Behandlungsgut bezeichnet. Zu behandeln sind sowohl Vollflächen an den Oberflächen der Bauteile, als auch strukturierte Flächen mit z.B. sehr feinen Leiterzügen mit kleinen Breiten von ca. 10 µm. In diesen vollflächigen oder strukturierten Leiterplatten befinden sich meist auch Durchgangslöcher und / oder Sacklöcher. Beim Galvanisieren sind auch die Wände dieser Löcher zu behandeln. Es muß das elektrolytisch abzuscheidende Metall, bei Leiterplatten meist Kupfer, in die Löcher gebracht werden. Bei Sacklöchern kommt es zunehmend auch vor, dass diese mit Metall vollkommen gefüllt werden müssen. Dies wird als Sacklochfüllung oder kurz Füllung bezeichnet.

In Anlagen für derartige elektrolytische Behandlungen wird das Behandlungsgut in horizontaler oder vertikaler Ausrichtung durch die mit Elektrolyt gefüllten elektrolytischen Zellen transportiert. In gleicher Ausrichtung zum Behandlungsgut befinden sich einseitig oder beidseitig in den elektrolytischen Zellen dem Behandlungsgut planparallel gegenüber stehend Elektroden. Sie bilden die Gegenelektroden zu den elektrisch leitfähigen Oberflächen des Behandlungsgutes. Als Gegenelektroden kommen sowohl im Elektrolyten lösliche als auch unlösliche vor. Die Erfindung betrifft sowohl das elektrolytische Metallisieren als auch das elektrolytische Ätzen. Beim Metallisieren des Behandlungsgutes bilden die Gegenelektroden die Anoden und das Behandlungsgut ist die Kathode. Beim elektrolytischen Ätzen sind die Elektroden umgekehrt gepolt. Zur Vereinfachung der Beschreibung wird die Erfindung nachfolgend nur noch an Hand des Galvanisierens beschrieben. Die Erfindung eignet sich zur Anwendung von Gleichstromquellen ebenso wie für unipolare Pulsstromquellen oder bipolare Pulsstromquellen als elektrolytische Badstromquellen. Bei den unipolaren Pulsstromquellen wird der Badstrom zyklisch unterbrochen. Der Strommittelwert ist in Abhängigkeit von den Stromlücken kleiner, als der Spitzenwert des Stromes.

Beim bipolaren Pulsstrom wird der Badstrom zyklisch umgepolt. In dieser Zeit wird nicht galvanisiert sondern elektrolytisch geätzt. Damit eine Metallisierung erfolgen kann, muß die Galvanisierstrommenge, d.h. Strom mal Zeit, größer sein, als die Ätzstrommenge. Kurz gesagt, es muß der Badstrom überwiegen, d.h. die zu galvanisierenden Bauteile müssen überwiegend kathodisch gegen die Anoden gepolt sein. Nachfolgend ist bei der Angabe der Polarität die überwiegende Polarität zu verstehen.

Beim Behandlungsgut kommen an den Oberflächen vollständig elektrisch leitfähige Flächen, so genannte Vollflächen vor. Bei anderem Behandlungsgut sind an den Oberflächen nur Strukturen wie z.B. Leiterzüge zu galvanisieren. Nicht zu behandelnde Bereiche sind mit einem elektrisch isolierenden Resist abgedeckt. Bei Vollflächen werden die Kanten des Behandlungsgutes in Folge der dort auftretenden Feldlinienkonzentration intensiver behandelt, als die inneren Flächen. Bei strukturierten Oberflächen werden die Kanten der Strukturen auch innerhalb des Strukturbildes bevorzugt galvanisiert.

Zur Verringerung der Kanteneffekte beziehungsweise der Spitzeneffekte, die bei der elektrolytischen Behandlung in Durchlaufanlagen auftreten, sind verschiedene Maßnahmen bekannt. Im Wesentlichen beruhen sie auf der Verwendung eines kleinen oder sehr kleinen Anoden-/Kathodenabstandes im Vergleich zu den in der Praxis vorkommenden Durchlauf-Galvanisieranlagen mit einem Anoden-/Kathodenabstand von 20 mm bis 75 mm. Die in der Druckschrift DE 44 17 551 C2 vorgeschlagene Vorrichtung verwendet zum Galvanisieren einen Abstand der Elektroden, der kleiner ist als das 30 fache der Strukturabmessungen. Dadurch wird die Spitzenwirkung, die auf die Kanten der Strukturen wirkt, verringert. Auf das Galvanisieren von Löchern und Sacklöchern wird in dieser Druckschrift nicht eingegangen. Einen noch kleineren Anoden-/Kathodenabstand beschreibt die Druckschrift DE 44 17 550 C1. Hier dient der elektrisch isolierende Resist beim Strukturgalvanisieren als Abstandshalter. Auf die Auswirkungen dieses Verfahrens auf die Loch- und Sacklochgalvanisierung wird nicht eingegangen. Als nachteilig bei beiden Erfindungen erweist sich auch die von den anodischen Walzen gegebenen kleinen Anodenflächen im Vergleich zu den Kathodenflächen. Diesen Nachteil vermeidet die Erfindung, die in der Druckschrift DE 100 43 814 C1 beschrieben ist. Bei einem sehr kleinen Anoden-/Kathodenabstand werden die Oberflächen des Behandlungsgutes elektrolytisch behandelt. Als Abstandshalter dient ein sehr dünner Ionen durchlässiger Isolierwerkstoff. Dies ermöglicht eine präzise Galvanisierung der Strukturen an den Oberflächen.

Aus der WO 03/072855 A1 geht ein Verfahren zur elektrolytischen Metallisierung von Lochwänden und Strukturen hervor, bei dem angestrebt wird, bei der Metallisierung der Oberflächen und der Bohrungen einen großen Abstand zwischen den Anoden und den Bauteilen zu verwirklichen, während bei einem nachfolgenden elektrolytischen Ätzvorgang ein geringer Abstand zwischen Kathode und Bauteil vorgesehen ist, um somit eine gute Beschichtung von Löchern zu erreichen. Im Hinblick auf die Strömung des Elektrolyts in der galvanischen Zelle wird angegeben, dass Elektrolyt-Sprührohre vorgesehen werden können. Diese sind entweder zur Durchströmung der Elektroden mit Elektrolyt vorgesehen oder dienen einer Anströmung der Bauteile von der Seite.

Aus der EP 1 083 245 A2 sind Sprührohre für Elektrolyt bekannt, deren Ausrichtung so gewählt ist, dass der ausströmende Elektrolyt unter einem Winkel auf die Oberfläche der Bauteile auftrifft.

Insgesamt ist dem Stand der Technik zu entnehmen, dass zur präzisen elektrolytischen Behandlung von Bauteilen ein kleiner oder sehr kleiner Anoden-/Kathodenabstand erforderlich ist. Allerdings wird der Einfluß auf das Galvanisieren von Durchgangslöchern und Sacklöchern bei diesen kleinen Abständen nicht beschrieben. Nachteilig ist bei dem Stand der Technik auch der spezielle anlagentechnische Mehraufwand, der aufgewendet werden muß.

Aufgabe der vorliegenden Erfindung ist es, die Oberflächen von vollflächigen oder strukturierten Oberflächen präzise elektrolytisch zu behandeln, wobei insbesondere auch Durchgangslöcher und Sacklöcher und diese ohne oder mit Füllung eingeschlossen sind. Dabei soll der anlagentechnische Aufwand im Vergleich zu einer bekannten Durchlaufanlage nicht wesentlich höher sein.

Gelöst wird die Aufgabe durch das Verfahren gemäß der Patentansprüche 1 bis 7 und durch die Vorrichtung gemäß der Patentansprüche 8 bis 11.

Bei Versuchen hat sich gezeigt, dass auch bei einem großen oder sehr großen Anoden-/Kathodenabstand eine sehr gleichmäßige elektrolytischen Behandlung erfolgt, wenn zugleich ein bipolarer Pulsstrom angewendet wird. In diesem Falle sind nahezu die gleich großen mittleren Stromdichten anwendbar, wie bei den bekannten Durchlaufanlagen zur elektrolytischen Behandlung von Leiterplatten mit 20 mm bis 75 mm Anoden-/Kathodenabstand. Durch den den bipolaren Pulsstrom und den großen Anoden-/Kathodenabstand wird auch eine sehr gute Lochgalvanisierung erreicht. Dies betrifft sowohl Durchgangslöcher als auch Sacklöcher. Auch das Füllen von Sacklöchern erfolgt in der erfindungsgemäßen elektrolytischen Zelle mit einem sehr großen Anoden-/Kathodenabstand und mit bipolarer Pulsstromspeisung überraschend gut, wenn zugleich die Sacklöcher mit Elektrolyt aus Sprührohren angeströmt werden. Der Anströmwinkel, unter dem der Elektrolyt gegen das Behandlungsgut strömt, muß dabei einen Winkel aufweisen, der von der Senkrechten um 10° bis 45° abweicht.

Der große Anoden-/Kathodenabstand erweist sich bei der Konstruktion der elektrolytischen Zelle als sehr vorteilhaft. Zur Anordnung der Sprührohre, die schmal in Transportrichtung und dafür sehr hoch dimensioniert werden können, steht ein großer Konstruktionsraum zur Verfügung. Im Sinne der Erfindung beträgt ein großer Anoden-/Kathodenabstand mindestens 100 mm und ein sehr großer Anoden-/Kathodenabstand 500 mm.

Die einzustellenden Parameter der Pulsstromquellen richten sich nach den Anforderungen, die das Behandlungsgut stellt und nach den Eigenschaften des jeweils verwendeten Elektrolyten. Dadurch ergibt sich ein weiter Bereich der einzustellenden Pulszeiten und Pulsamplituden, die sich zyklisch wiederholen. Diese liegen in der Praxis beim Vorwärtsstrom (Galvanisieren) im Bereich von 0,5 ms bis 200 ms, bevorzugt im Bereich von 4 ms bis 100 ms. Der Rückwärtsstrom (elektrolytisches Ätzen) liegt im Bereich von 0,05 ms bis 30 ms, bevorzugt von 1 ms bis 10 ms. Zusätzlich werden in der Praxis bei bestimmten Anwendungsfällen die Vorwärtsströme zyklisch unterbrochen, z.B. zur Vermeidung von kurzzeitigen Überströmen. Die Unterbrechungszeiten liegen im Bereich der Zeiten, die für den Rückwärtsstrom verwendet werden. Die Unterbrechung kann auch bis zu 50 ms betragen. In diesen Zeitbereichen liegen auch die zyklischen Stromunterbrechungen bei unipolarem Pulsstrom, der auch für die Erfindung anwendbar ist. In diesem Falle sind bei momentanen Stromdichten von 1 A/dm² bis zu 15 A/dm² mittlere Stromdichten von 10 A/dm² oder weniger einzustellen.

Die Amplituden des Vorwärtsstromes Iv und des Rückwärtsstromes Ir stehen in einem bestimmten Verhältnis. Dieses liegt im Bereich von Iv : Ir = 1: 0,1 bis 1: 15. Bevorzugt 1: 4. Alle diese Parameter sind bei den handelsüblich verfügbaren Pulsgleichrichtern einstellbar. Das eingestellte Pulsbild wiederholt sich zyklisch. Durch Versuche wird für das jeweilige Produkt der optimale Parametersatz ermittelt. Dabei erweisen sich die Pulsströme besonders wirkungsvoll beim Füllen von Behandlungsgut mit Mikro-Sacklöchern unter Verwendung von elektrolytischen Zellen mit großem oder sehr großem Anoden-/Kathodenabstand. Als sehr groß sind z.B. 500 mm Anoden-/Kathodenabstand zu verstehen. Bereits ein Abstand von 100 mm bis 150 mm erweist sich zum Füllen der Sacklöcher als wirkungsvoll.

Die für das jeweilige Behandlungsgut einzustellenden momentanen Stromdichten betragen in der Praxis bei bipolarem Pulsstrom für den Vorwärtsstrom 1 A/dm² bis zu 20 A/dm², bevorzugt 3 A/dm² bis 10 A/dm². Die Stromdichten für den Rückwärtsstrom betragen 4 A/dm² bis zu 40 A/dm², bevorzugt 8 A/dm² bis zu 25 A/dm². Dies ergibt mittlere zu bevorzugende Stromdichten von 15 A/dm² oder weniger.

Ein Ausführungsbeispiel der Erfindung wird nachfolgend mit Bezug auf die Zeichnung näher erläutert.

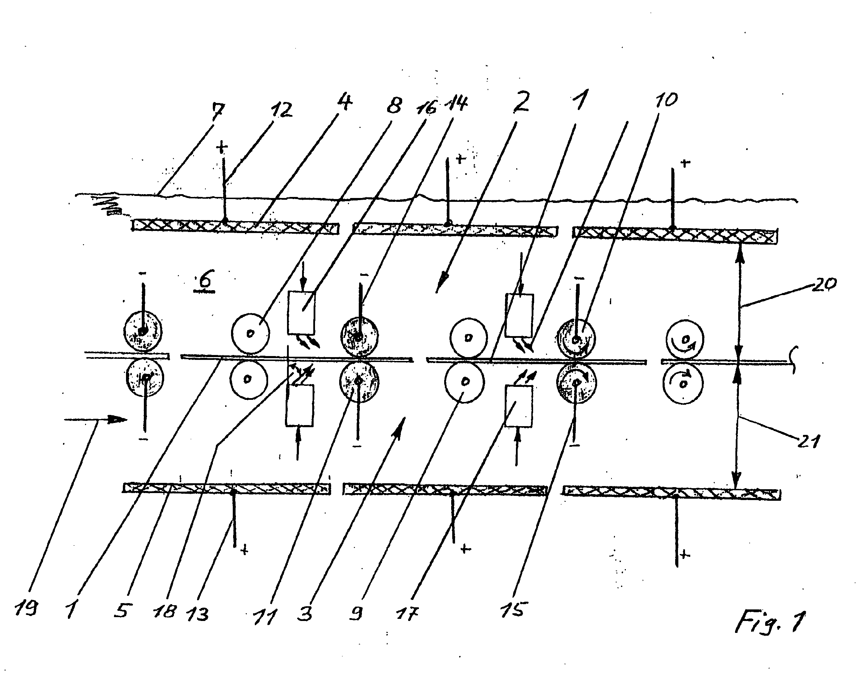

Die Figur 1 zeigt schematisch in der Seitenansicht einen Ausschnitt einer erfindungsgemäßen Durchlaufanlage.

Das Behandlungsgut 1 wird von rotierenden oberen und unteren Transportwalzen 8, 9 und von Kontaktwalzen 10, 11 durch die oberen und unteren elektrolytischen Zellen 2, 3 transportiert. Mittels der Kontaktwalzen wird der Badstrom dem Behandlungsgut zugeführt. Es sind auch andere Stromzuführungen zum Behandlungsgut anwendbar, z.B. Klammern, die das durch die Anlage zu transportierende Behandlungsgut an einem oder an beiden Rändern ergreifen und kontaktieren. Auch Kontakträder, die seitlich auf dem Behandlungsgut abrollen, können für diese Erfindung angewendet werden. Die Transportrichtung zeigt der Richtungspfeil 19.

Die elektrolytischen Zellen sind mit Elektrolyt 6 gefüllt wobei das Niveau 7 über den oberen Anoden 4 steht. Die oberen Anoden 4 sind mittels der Anodenanschlüsse 12 mit mindestens einem nicht dargestellten Gleichrichter verbunden. Bevorzugt werden Pulsgleichrichter verwendet. Es sind jedoch auch Gleichstrom-Gleichrichter verwendbar. Beim Galvanisieren sind die überwiegend negativen Pole der Gleichrichter über die Kathodenanschlüsse 14, 15 mit den Kontaktwalzen 10, 11 elektrisch verbunden. Die oberen Anoden 4 bilden mit dem Behandlungsgut die oberen elektrolytischen Zellen 2 und die unteren Anoden 5 die unteren elektrolytischen Zellen 3. Als Anoden sind im Elektrolyt lösliche sowie auch unlösliche verwendbar. In diesen elektrolytischen Zellen 2, 3 sind zwischen dem Behandlungsgut 1 und den Anoden quer zur Transportrichtung obere und untere Sprührohre 16, 17 angeordnet. Durch diese Sprührohre wird der Elektrolyt im Kreislauf mittels nicht dargestellter Pumpen und Filter durch die elektrolytischen Zellen 2, 3 gefördert. Der Elektrolyt tritt bevorzugt bei der Behandlung von Löchern, insbesondere bei der Füllung von Sacklöchern unter einem bestimmten Elektrolyt-Austrittswinkel 18 aus. Dieser Winkel 18 beträgt 10° bis 45° gegen die Senkrechte zum Behandlungsgut. In diesem Falle erfolgt ein besonders intensiver Stoffaustausch in den Löchern. Dies ist Voraussetzung für die Anwendung von hohen Stromdichte. Unter hoher Stromdichte für den Vorwärtsstrom sind z.B. 12 A/dm² zu verstehen. Bei sehr kleinen Löchern und Sacklöchern, z.B. mit einem Durchmesser von 0,1 mm und einer Tiefe von größer 0,1 mm ist es zweckmäßig, mit kleineren mittleren Stromdichten zu galvanisieren, z.B. mit 6 A/dm².

Den oberen Anoden-/Kathodenabstand kennzeichnet der Doppelpfeil 20. Den unteren Anoden-/Kathodenabstand kennzeichnet der Doppelpfeil 21. In der Regel werden beide Abstände in einer Durchlaufanlage gleich groß gewählt. In der Praxis kommt Behandlungsgut vor, das an der Oberseite und Unterseite unterschiedliche Strukturen und Löcher aufweist, oder es sind unterschiedlich dicke Schichten aufzubauen. Wenn dies permanent der Fall ist, dann können die Anoden-/Kathodenabstände den Erfordernissen angepaßt, d.h. unterschiedlich groß gewählt werden. In diesem Falle ist es vorteilhaft, den oberen Anoden-/Kathodenabstand kleiner zu wählen, um das Niveau 7 des Elektrolyten niedrig zu halten. Der Elektrolyt muß dann nicht so hoch angestaut werden, was zu einer konstruktiv einfacheren Anlage führt. Das Behandlungsgut wird in der entsprechenden Lage durch die Durchlaufanlage transportiert.

### Bezugszeichenliste

- 1: Behandlungsgut, Bauteil
- 2: elektrolytische Zelle oben
- 3: elektrolytische Zelle unten
- 4: Elektrode, Anode oben
- 5: Elektrode, Anode unten
- 6: Elektrolyt
- 7: Niveau des Elektrolyten
- 8: Transportwalze oben
- 9: Transportwalze unten
- 10: Kontaktwalze oben
- 11: Kontaktwalze unten
- 12: Anodenanschluß oben
- 13: Anodenanschluß unten
- 14: Kathodenanschluß oben
- 15: Kathodenanschluß unten
- 16: Sprührohr oben
- 17: Sprührohr unten
- 18: Elektrolyt-Austrittswinkel
- 19: Transportrichtungspfeil
- 20: Anoden-/Kathodenabstand oben
- 21: Anoden-/Kathodenabstand unten

## Patentansprüche

1. Verfahren zur elektrolytischen Behandlung von ebenen
Bauteilen in Durchlaufanlagen, die in horizontaler oder vertikaler Ausrichtung zwischen Elektroden von elektrolytischen Zellen (2, 3) transportiert werden, wobei die Oberflächen der Bauteile mit elektrisch leitfähigen, vollflächigen oder strukturierten elektrolytisch zu behandelnden Schichten versehen sind, die mit Durchgangs- und / oder Sacklöchern versehen sind, die elektrolytisch zu metallisieren oder zu füllen sind, wobei die Behandlung in den elektrolytischen Zellen (2, 3) mit einem Anoden/Kathodenabstand (20, 21) erfolgt, der größer als 100 mm ist und die elektrolytischen Zellen mit unipolarem oder bipolarem Pulsstrom gespeist werden, **dadurch gekennzeichnet, dass** Elektrolyt aus Elektrolyt-Sprührohren (16, 17) ausströmt, die zwischen den Anoden (4, 5) und den Bauteilen (1) angeordnet sind.

2. Verfahren nach Anspruch 1, **dadurch gekennzeichnet,**
**dass** zur elektrolytischen Behandlung und Füllung von Sacklöchern die Oberflächen des Bauteils (1) in den elektrolytischen Zellen unter einem Winkel von 10° bis 45° gegen die Senkrechte angeströmt werden.

3. Verfahren nach einem der Ansprüche 1 oder 2, **dadurch**
**gekennzeichnet, dass** in den elektrolytischen Zellen bei unipolarem Pulsstrom mittlere Stromdichten eingestellt werden, die kleiner 10 A/dm² betragen.

4. Verfahren nach einem der Ansprüche 1 oder 2, **dadurch**
**gekennzeichnet, dass** bei Verwendung von bipolarem Pulsstrom ein Stromdichte-Mittelwert in den elektrolytischen Zellen eingestellt wird, der kleiner 15 A/dm² beträgt.

5. Verfahren nach einem der Ansprüche 1 bis 4, **dadurch**
**gekennzeichnet, dass** zur elektrolytischen Behandlung mit unipolarem Pulsstrom momentane Stromdichten von 1 A/dm² bis zu 15 A/dm² verwendet werden.

6. Verfahren nach einem der Ansprüche 1 bis 5, **dadurch**
**gekennzeichnet, dass** zur elektrolytischen Behandlung Pulsstrom verwendet wird mit momentanen Stromdichten für den Vorwärtsstrom von 1 A/dm² bis 20 A/dm² und für den Rückwärtsstrom von 4 A/dm² bis zu 40 A/dm² und Pulszeiten für den Vorwärtsstrom von 0,5 ms bis zu 200 ms und für den Rückwärtsstrom von 0,05 ms bis zu 30 ms, sowie Unterbrechungen des Vorwärtsstromes von 0,05 ms bis zu 50 ms.

7. Verfahren nach einem der Ansprüche 1 bis 4, **dadurch**
**gekennzeichnet, dass** als Elektroden der elektrolytischen Zellen lösliche oder unlösliche Anoden dienen.

8. Vorrichtung zur elektrolytischen Behandlung von
ebenen Bauteilen in Durchlaufanlagen, die in horizontaler oder vertikaler Ausrichtung zwischen Elektroden von elektrolytischen Zellen (2, 3) transportiert werden, wobei die Oberflächen der Bauteile mit elektrisch leitfähigen, vollflächigen oder strukturierten elektrolytisch zu behandelnden Schichten versehen sind, die mit Durchgangs- und / oder Sacklöchern versehen sind, die elektrolytisch zu metallisieren oder zu füllen sind, zur Durchführung des Verfahrens nach den Ansprüchen 1 bis 7, wobei ein Anoden/Kathodenabstand der elektrolytischen Zellen größer als 100 mm ist und mindestens eine unipolare oder bipolare Pulsstromquelle zur Badstromversorgung der elektrolytischen Zelle(n) vorgesehen ist, **dadurch gekennzeichnet, dass** Elektrolyt-Sprührohre (16, 17) zwischen den Anoden (4, 5) und den Bauteilen (1) angeordnet sind.

9. Vorrichtung nach Anspruch 8, **dadurch gekennzeichnet,**
**dass** ein Elektrolyt-Austrittswinkel (18) der Elektrolyt-Sprührohre (16, 17) 10° bis 45° gegen die Senkrechte zur Oberfläche des Bauteils (1) beträgt.

10. Vorrichtung nach einem der Ansprüche 8 oder 9,
**gekennzeichnet durch** mindestens eine bipolare Pulsstromquelle mit folgenden Einstellmöglichkeiten:
Zeit für den Vorwärtsstrom Iv von 0,5 ms bis 200 ms
Zeit für den Rückwärtsstrom Ir von 0,05 ms bis 30 ms
Amplitude für den Vorwärtsstrom zur Amplitude für den Rückwärtsstrom Iv : Ir = 1: (0,1 bis 15) Unterbrechung des Vorwärtsstromes Iv von 0,05 ms bis zu 50 ms.

11. Vorrichtung nach einem der Ansprüche 8 oder 9,
**gekennzeichnet durch** mindestens eine unipolare Pulsstromquelle zur Speisung der elektrolytischen Zellen mit Pulszeiten für die Galvanisierung im Bereich von 0,5 ms bis 200 ms, bevorzugt im Bereich von 4 ms bis 100 ms.

## Claims

1. Process for electrolytic treatment of flat components in continuous-pass plants, said components being transported in horizontal or vertical orientation between electrodes of electrolytic cells (2, 3), the surfaces of the components being provided with electrically conductive, full-surface or structured layers to be treated electrolytically which are provided with through-holes and/or blind holes which are to be electrolytically metallised or filled, the treatment in the electrolytic cells (2, 3) being undertaken with an anode-cathode spacing (20, 21) that is greater than 100 mm, and the electrolytic cells being fed with unipolar or bipolar pulsed current, **characterised in that** electrolyte flows out of electrolyte spray pipes (16, 17) which are arranged between the anodes (4, 5) and the components (1).

2. Process according to Claim 1, **characterised in that** for the purpose of electrolytic treatment and filling of blind holes the surfaces of the component (1) in the electrolytic cells are subjected to incident flow at an angle of 10º to 45º relative to the perpendicular.

3. Process according to one of Claims 1 or 2, **characterised in that** in the case of unipolar pulsed current in the electrolytic cells average current densities are adjusted that amount to less than 10 A/dm2.

4. Process according to one of Claims 1 or 2, **characterised in that** in the case where use is made of bipolar pulsed current an average value of the current density in the electrolytic cells is adjusted that amounts to less than 15 A/dm2.

5. Process according to one of Claims 1 to 4, **characterised in that** for the purpose of electrolytic treatment with unipolar pulsed current use is made of instantaneous current densities from 1 A/dm2 up to 15 A/dm2.

6. Process according to one of Claims 1 to 5, **characterised in that** for the purpose of electrolytic treatment use is made of pulsed current having instantaneous current densities from 1 A/dm2 to 20 A/dm2 for the forward current and from 4 A/dm2 up to 40 A/dm2 for the reverse current and pulse times from 0.5 ms up to 200 ms for the forward current and from 0.05 ms up to 30 ms for the reverse current, as well as interruptions of the forward current from 0.05 ms to 50 ms.

7. Process according to one of Claims 1 to 4, **characterised in that** soluble or insoluble anodes serve as electrodes of the electrolytic cells.

8. Apparatus for electrolytic treatment of flat components in continuous-pass plants, said components being transported in horizontal or vertical orientation between electrodes of electrolytic cells (2, 3), the surfaces of the components being provided with electrically conductive, full-surface or structured layers to be treated electrolytically which are provided with through-holes and/or blind holes which are to be electrolytically metallised or filled, for carrying out the process according to Claims 1 to 7, wherein an anode-cathode spacing of the electrolytic cells is greater than 100 mm and at least one unipolar or bipolar source of pulsed current is provided for the purpose of supplying the bath current of the electrolytic cell(s), **characterised in that** electrolyte spray pipes (16, 17) are arranged between the anodes (4, 5) and the components (1).

9. Apparatus according to Claim 8, **characterised in that** an electrolyte-emission angle (18) of the electrolyte spray pipes (16, 17) amounts to 10º to 45º relative to the perpendicular to the surface of the component (1).

10. Apparatus according to one of Claims 8 or 9, **characterised by** at least one bipolar source of pulsed current with the following adjustment options:
time for the forward current Iv from 0.5 ms to 200 ms time for the reverse current Ir from 0.05 ms to 30 ms amplitude for the forward current relative to the amplitude for the reverse current Iv:Ir = 1:(0.1 to 15)
interruption of the forward current Iv from 0.05 ms to 50 ms.

11. Apparatus according to one of Claims 8 or 9, **characterised by** at least one unipolar source of pulsed current for the purpose of feeding the electrolytic cells, with pulse times for the galvanisation within the range from 0.5 ms to 200 ms, preferably within the range from 4 ms to 100 ms.

## Revendications

1. Procédé pour le traitement électrolytique de pièces planes dans des installations fonctionnant en continu, qui sont transportées en orientation horizontale ou verticale entre des électrodes de cellules électrolytiques (2, 3), les surfaces des pièces étant pourvues de couches électroconductrices pleines ou structurées à traiter électrolytiquement qui sont pourvues de trous traversants et/ou borgnes à métalliser ou remplir électrolytiquement, le traitement dans les cellules électrolytiques (2, 3) ayant lieu avec une distance anode-cathode (20, 21) qui est supérieure à 100 mm et les cellules électrolytiques étant alimentées en courant pulsé unipolaire ou bipolaire, **caractérisé en ce que** de l'électrolyte sort de tubes de pulvérisation d'électrolyte (16, 17) qui sont disposés entre les anodes (4, 5) et les pièces (1).

2. Procédé selon la revendication 1, **caractérisé en ce que** pour le traitement et remplissage électrolytique de trous borgnes, les surfaces de la pièce (1) sont balayées dans les cellules électrolytiques sous un angle de 10° à 45° par rapport à la verticale.

3. Procédé selon l'une des revendications 1 ou 2, **caractérisé en ce que**, dans le cas d'un courant pulsé unipolaire, on règle dans les cellules électrolytiques des densités de courant moyennes qui sont inférieures à 10 A/dm².

4. Procédé selon l'une des revendications 1 ou 2, **caractérisé en ce qu'**en cas d'utilisation d'un courant pulsé bipolaire, on règle dans les cellules électrolytiques une densité de courant moyenne qui est inférieure à 15 A/dm².

5. Procédé selon l'une des revendications 1 à 4, **caractérisé en ce que** pour le traitement électrolytique avec un courant pulsé unipolaire, on utilise des densités de courant instantanées de 1 A/dm² à 15 A/dm².

6. Procédé selon l'une des revendications 1 à 5, **caractérisé en ce que** pour le traitement électrolytique, on utilise un courant pulsé avec des densités de courant instantanées de 1 A/dm² à 20 A/dm² pour le courant direct et de 4 A/dm² à 40 A/dm² pour le courant inverse et des durées d'impulsion de 0,5 ms à 200 ms pour le courant direct et de 0,05 ms à 30 ms pour le courant inverse ainsi que des pauses de 0,05 ms à 50 ms pour le courant direct.

7. Procédé selon l'une des revendications 1 à 4, **caractérisé en ce que** l'on se sert d'anodes solubles ou insolubles comme électrodes des cellules électrolytiques.

8. Dispositif pour le traitement électrolytique de pièces planes dans des installations fonctionnant en continu, qui sont transportées en orientation horizontale ou verticale entre des électrodes de cellules électrolytiques (2, 3), les surfaces des pièces étant pourvues de couches électroconductrices pleines ou structurées à traiter électrolytiquement qui sont pourvues de trous traversants et/ou borgnes à métalliser ou remplir électrolytiquement, pour réaliser le procédé selon les revendications 1 à 7, dans lequel une distance anode-cathode des cellules électrolytiques est supérieure à 100 mm et il est prévu au moins une source de courant pulsé unipolaire ou bipolaire pour l'alimentation électrique de bain de la ou les cellule(s) électrolytique(s), **caractérisé en ce que** des tubes de pulvérisation d'électrolyte (16, 17) sont disposés entre les anodes (4, 5) et les pièces (1).

9. Dispositif selon la revendication 8, **caractérisé en ce qu'**un angle de sortie d'électrolyte (18) des tubes de pulvérisation d'électrolyte (16, 17) vers la surface de la pièce (1) a une valeur de 10° à 45° par rapport à la verticale.

10. Dispositif selon l'une des revendications 8 ou 9, **caractérisé par** au moins une source de courant pulsé bipolaire ayant les possibilités de réglage suivantes :
durée pour le courant direct Iv de 0,5 ms à 200 ms
durée pour le courant inverse Ir de 0,05 ms à 30 ms
amplitude pour le courant direct par rapport à l'amplitude pour le courant inverse Iv : Ir = 1 : (0, 1 à 15)
pause du courant direct Iv de 0,05 ms à 50 ms.

11. Dispositif selon l'une des revendications 8 ou 9, **caractérisé par** au moins une source de courant pulsé unipolaire pour alimenter les cellules électrolytiques avec des durées d'impulsion pour la galvanisation comprises entre 0,5 ms et 200 ms, de préférence entre 4 ms et 100 ms.
